# EUROPEAN PATENT APPLICATION

(11) **EP 4 203 318 A1**
(43) Date of publication of application: **28.06.2023**
(21) Application number: 22206889.2
(22) Date of filing: 11.11.2022
(51) Int. Cl.: H03K 19/00, H03K 19/003, G05F 1/10, G05F 1/46

(54) **THERMOMETER ENCODING AND GANGING OF POWER GATES**

(30) Priority: 23.12.2021 US 202117561246
(71) Applicant: INTEL Corporation, Santa Clara, CA 95054 (US)
(72) Inventor: PAILLET, Fabrice, Portland, 97229 (US); HYVONEN, Sami, Beaverton, 97007 (US); MATTHEW, George, Beaverton, 97078 (US); HODGSON, James, Hillsboro, 97124 (US); RAMASUNDAR, Anand, Portland, 97229 (US); CHILKA, Sandeep, Portland, 97229 (US); SOUNDARARAJAN, Bharadwaj, Portland, 97229 (US); CARLO RODRIGUEZ, Sergio, Hillsboro, 97124 (US); CHEN, Po-Cheng, Tigard, 97223 (US); RENZEMA, Cary, North Plains, 97133-8153 (US)
(74) Representative: HGF

(57) **Abstract**

A digitally selectable power gate with thermometer-encoded upper bits may provide solutions for problems digital power gate-based regulators. These solutions may include the use of a fully binary power gate, either in structure or by local decoding of binary control signal to an addressable row-based power gate. This provides improved performance over a row-based code rotation, which is intended to avoid instantaneous overheating of power gate devices but may not mitigate aging effects. Another solution includes ganging a primary DLVR and one or more secondaries. The primary DLVR may include a voltage sense and active controller, which may forward its PG code to secondary instances. Therm and current sensor rotation may be performed locally at the secondaries and a current monitor data may be rolled up from all ganged DLVRs.

## Description

### TECHNICAL FIELD

Embodiments described herein generally relate to digitally controlled power gates.

### BACKGROUND

Digital power gate-based regulators may require fine grain enabling of power gates devices with orders of magnitude difference in size. The issue of monotonicity of the power gate array becomes a significant problem when large bit transitions occur. Non-monotonicity in the power gate may cause non-linear behavior of the controller and potential instability of the regulator. Additionally, when a subset of power gates transistors is enabled for a greater duration of the product lifetime than other power gates, they may age differently and exhibit non-monotonicity effects years or months after production. Aging differences may also affect accuracy in current sensing circuits.

### BRIEF DESCRIPTION OF THE DRAWINGS

In the drawings, which are not necessarily drawn to scale, like numerals may describe similar components in different views. Like numerals having different letter suffixes may represent different instances of similar components. Some embodiments are illustrated by way of example, and not limitation, in the figures of the accompanying drawings in which:
FIGs. 1A-1F are schematic views showing logic hierarchy of a power gate, according to an embodiment.
FIGs. 2A-2F are schematic views of a logic hierarchy of a power gate, according to an embodiment.
FIGs. 3A-3C are schematic views of a power gate unit floor plan, according to an embodiment.
FIG. 4 is a schematic view 400 of a DLVR and, according to an embodiment.
FIG. 5 is a schematic view 500 of a high aspect ratio DLVR and, according to an embodiment.
FIG. 6 is a schematic view 600 of distributed DLVRs and a, according to an embodiment.
FIG. 7 is a schematic view 700 showing DLVR digital, according to an embodiment.
FIGs. 8A-8B are schematic views of DLVR heat maps 800A-800B, according to an embodiment.
FIG. 9 is a schematic view of a simulated ganged DLVR topology, according to an embodiment.
FIG. 10 is a graph of simulated output DLVR currents, according to an embodiment.
FIG. 11 is a graph of simulated output DLVR voltages, according to an embodiment.
FIG. 12 is a flowchart illustrating a method, according to an embodiment.
FIG. 13 is a block diagram of a computing device, according to an embodiment.

### DETAILED DESCRIPTION

A digitally selectable (e.g., digital) power gate regulator with thermometer-encoded upper bits may help to provide solutions for problems digital power gate-based regulators. These solutions may include the use of a fully binary power gate, either in structure or by local decoding of binary control signal to an addressable row-based power gate. This provides improved performance over a row-based code rotation, which is intended to avoid instantaneous overheating of power gate devices but may not mitigate aging effects. These solutions may reduce or eliminate aging effects by incorporating thermometer encoding so no bits were deterministically on for a greater amount of time than any other bits.

The solutions described herein provide improved ageing and monotonicity performance through a digitally selectable power gate with the upper bits being thermometer encoded. Thermometer encoding may improve monotonicity over a fully binary encoded power gate, and may allow a deterministic code rotation to help combat effects of uneven transistor aging. In an example solution, a digital linear voltage regulator (DLVR) with a 15-bit binary raw controller code may map the upper 4 binary bits to 15 equally sized thermometer-encoded power gate sections (called "therms") and map the lower 11-bits directly to binary weighted power gate units. The thermometer encoded power gates with rotating addresses may be implemented in silicon in the DLVR intellectual property (IP) on a chip, for example.

These solutions may also include breaking top binary bits of a digital power gate into a larger amount of equally sized thermometer bits so that a maximum binary bit transition is significantly reduced. The issue of rapid aging of the lowest thermometer bits may be mitigated by executing a slow address rotation of all the thermometer bits, such as on a 1-8 ms time scale. One advantage of thermometer encoded power gates with slow address rotation is that the resolution of a binary encoded digital controller output may be extended while reducing likelihood of large non-monotonicities. A downside of introducing unequal aging in the power gate may be offset by slowly rotating the thermometer bits so that no single thermometer is on more than the others over a lifetime of the product.

These solutions may also include ganging a primary DLVR with one or more secondaries. The primary DLVR may include a voltage sense and active controller, which may forward its PG code to secondary instances. Therm and current sensor rotation may be performed locally at the secondaries and a current monitor (IMON) data may be rolled up from all ganged DLVRs. The ability to distribute voltage regulator power gates may be helpful for power domains that are narrower than the power gate or are very long in one direction. Breaking up a monolithic power gate allows for distribution of smaller segments that are easier to hook up to the power delivery network and may reduce IR drop across large domains.

The above discussion is intended to provide an overview of subject matter of the present patent application. It is not intended to provide an exclusive or exhaustive explanation of the invention. The description below is included to provide further information about the present patent application. In the following description, for purposes of explanation, numerous specific details are set forth to provide a thorough understanding of some example embodiments. It will be evident, however, to one skilled in the art that the present disclosure may be practiced without these specific details.

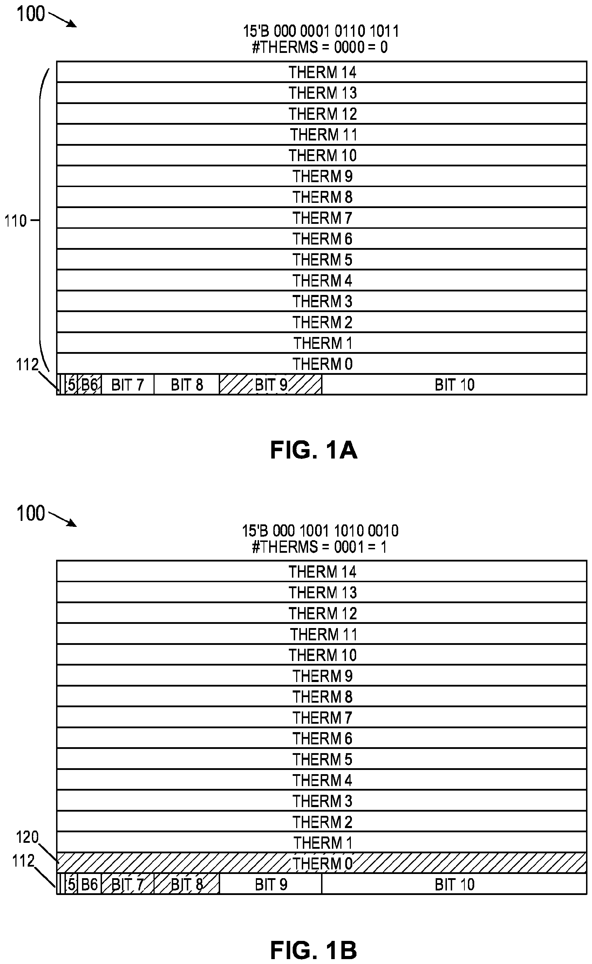

FIGs. 1A-1F are schematic views showing logic hierarchy of a power gate 100, according to an embodiment. FIGs. 1A-1F illustrate the general concept of thermometer-encoded power gate sections by showing the logic hierarchy therm power gates 110 and binary power gates 112. The bottom row may represent binary weighted power gates from bit 0 to bit 10. The 15 rows on top of the binary weighted power gates represent the upper 4 binary bits encoded in the therms.

FIG. 1A is a schematic view of a logic hierarchy of a power gate 100 having a small power gate (PG) code that can be mapped within the lower 11-bits in the binary weighted power gate units 112 without needing to map upper 4 binary bits to 15 therms 110. The PG code may be generated by a power code generation circuit and provided to the power gate 100. FIG. 1A shows a PG code with 15-bit code with the 4 most significant bits equal to 0 (e.g., bits 4, 7, 8, and 10). Since the bottom 11 bits are binary, they may continuously change with the PG code. FIG. 1B is a schematic view of a logic hierarchy of the power gate 100 shows the PG code extending to bit 11 and enabling the first therm 120.

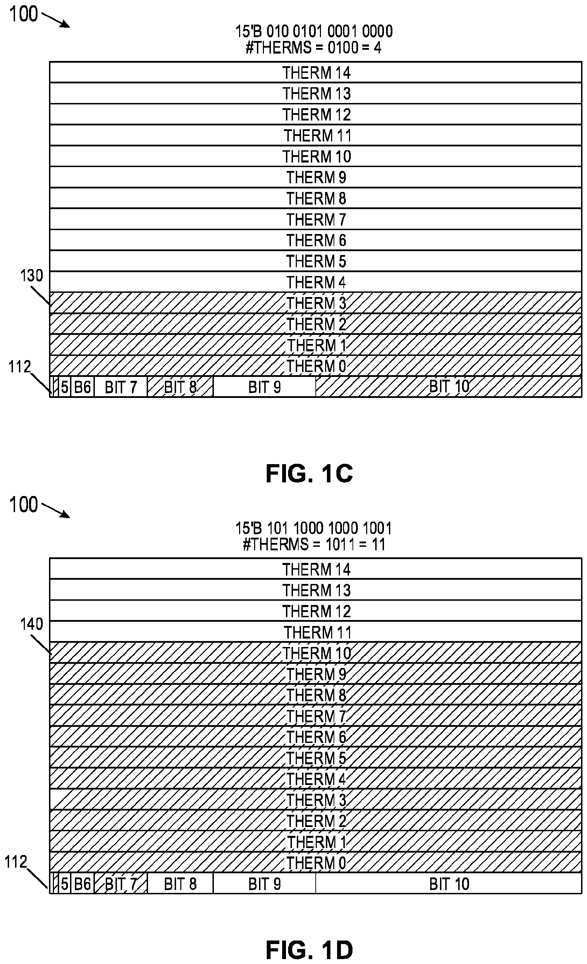

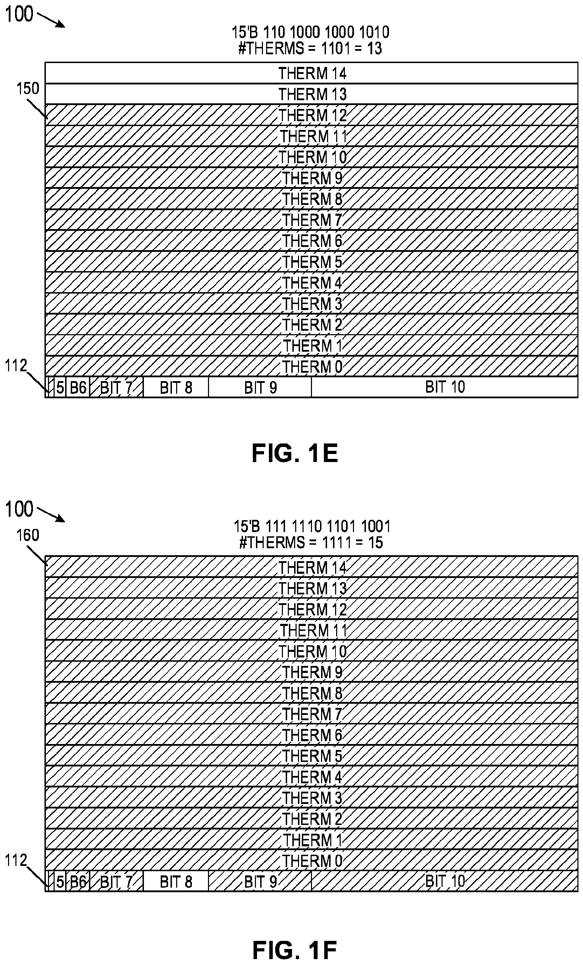

FIGs. 1C-1F are schematic views of logic hierarchy of the power gate 100 with increasing PG codes, where each figure shows activating more therms 130-160 in succession. FIGs. 1C-1F show the PG code increasing with the therms that were already on staying on. For example, FIG. 1C shows a group of four therms 130 (therms 0-3) as enabled. FIG. 1D shows a group of eleven therms 140 (therms 0-10). FIG. 1E shows a group of thirteen therms 150 (therms 0-12) as enabled. FIG. 1F shows a group of fifteen therms 160 (therms 0-14). A size of any non-monotonic behavior may be at its maximum when the binary bits are switching from bits 0-9 enabled to only bit 10 enabled. This may be a much smaller transition than going from bits 0-13 enabled to only bit 14 enabled.

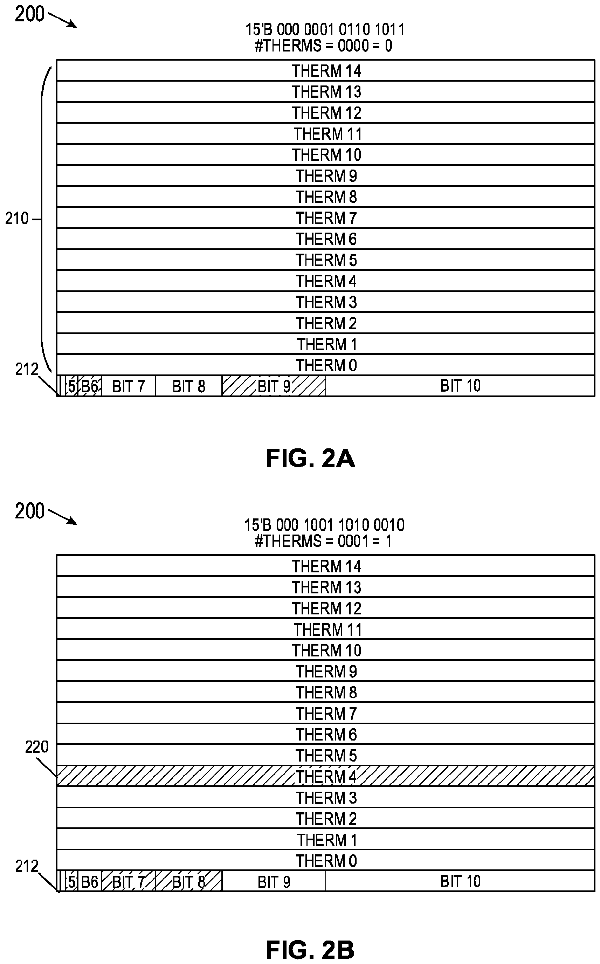

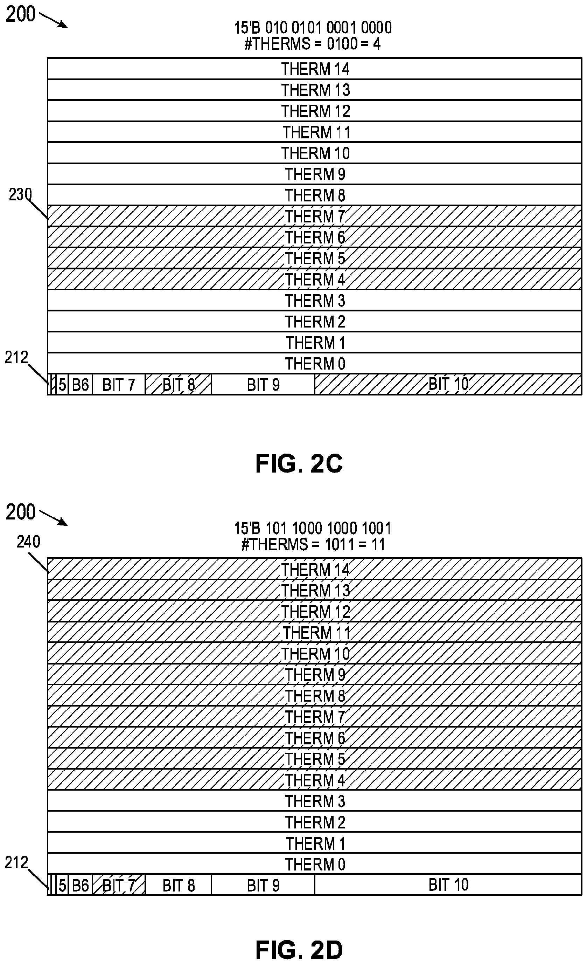

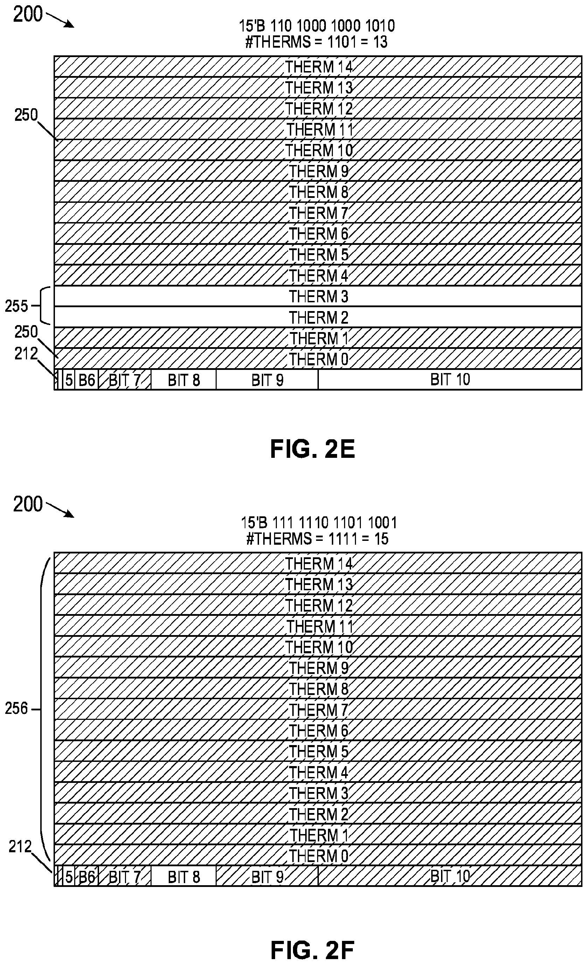

FIGs. 2A-2F are schematic views of a logic hierarchy of a power gate 200, according to an embodiment. The logic hierarchy shown in FIGs. 2A-2F are based on a different rotation from FIGs. 1A-1F. One potential problem that may be caused by thermometer encoding is that the lower therms may suffer aging effects, such as increased threshold voltage and lower conductivity, faster than upper therms because they are enabled more often than the upper therms. This problem may be addressed by rotating the therm bits to randomize the order of enabling and to make the aging process uniform across the therms. A deterministic code rotation circuit may generate a rotated binary raw controller code based on the PG code. For example, the deterministic code rotation circuit may include a barrel rotator circuit, and after a configurable time period between 1 millisecond (ms) and 8 ms, the addresses of the therms may be reordered using a barrel rotation. The deterministic code rotation circuit may also include other deterministic rotations to provide substantially uniform process aging across the therms. FIGs. 2A shows the power gate with no therms 210 enabled. FIG. 2B shows that a first therm 220 is now therm 4 instead of therm 0 as in FIG. 1B. FIG. 2C shows that a group of four therms 230 may extend from therm 4 to therm 7 and FIG. 2C shows that a group of ten therms 240 may extend from therm 4 to therm 14. FIG. 2E shows that a group of thirteen therms includes therms 0 and 1 and therm 4 to therm 14, but includes a group of inactive therms 255, which may be the second therm 2 and the third therm 3. FIG. 2F shows that a group of fifteen therms 256 may include therms 0 to 14.

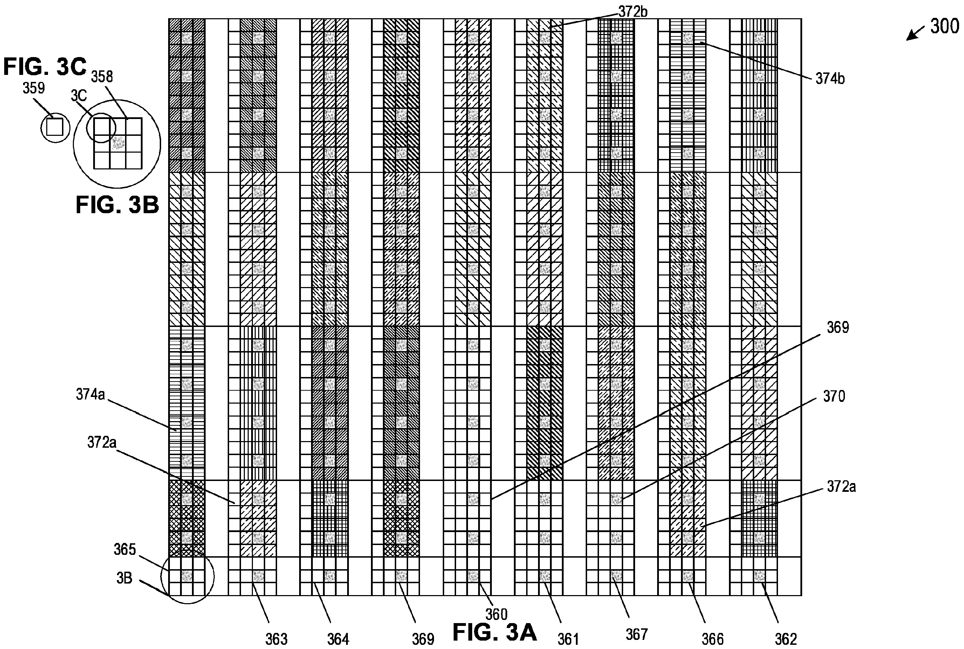

FIGs. 3A-3C are schematic views of a power gate unit floor plan 300, according to an embodiment. FIG. 3A shows a power gate unit floor plan or "slice" that may include binary bits and therm bits. As shown in FIG. 3A, the binary bits may be represented by white squares near the bottom of the slice (b0 - b10), while the therms are equally sized sections located above the binary bits (T0-T14).

More specifically, FIG. 3A shows a floorplan 300 of the smallest functional unit of the power gate that includes a full set of binary bits and therms. FIG. 3B shows a unit block 358 of the floorplan, which may include 9 bits. FIG. 3C shows a single bit 359. The smallest unit block in the floorplan 300 may be referred to herein as a "BB8" because when fully utilized it is equivalent to bit 8 in the PG code, where any bits lower than bit 8 consume the same area as bit 8 and the remaining transistor area is unused (e.g., dummified).

FIG. 3A shows that the floor plan 300 may include eleven binary bit blocks, shown as blocks 360-370, where block 0 is 360, block 1 is 361, block 2 is 362, block 3 is 363, block 4 is 364, block 5 is 365, block 6 is 366, block 7 is 367, block 8 is 368, block 9 is 369, and block 10 is 370. Bit 10 may include a quantity of 4 blocks (BB8s) and may be the largest binary bit.

FIG. 3A also shows therms, which may be twice the size of bit 10 such as to include 8 BB8s each. Each therm may be physically split into 2 blocks of 4 BB8s which may be located in different parts of the slice in order to more evenly distribute the load current. The numbered therms may also be randomly distributed throughout the slice so that current load is spread evenly as more therms are enabled. As shown in FIG. 3A, the two therm halves may be pattern-matched so that it is apparent where the two sections of 4 BB8s are located. For example, therm 7 may be located half 374b in the upper right corner and half 374a in the lower left. Therms may also be split into more than two portions. For example, a first therm 372 may be split into three portions in three locations, such as 372a, 372b, and 372c.

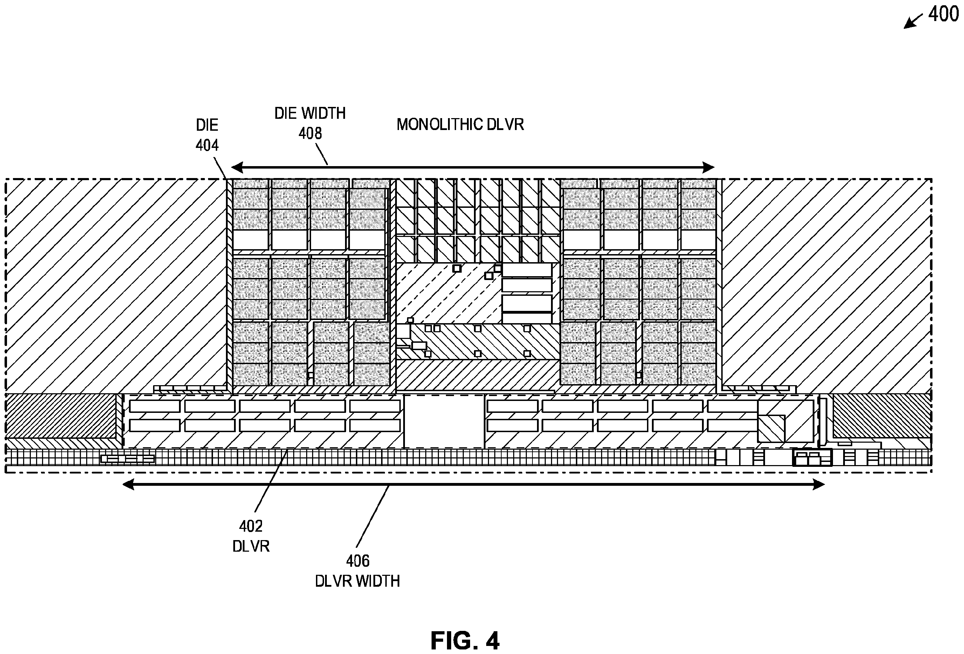

FIG. 4 is a schematic view 400 of a DLVR and die, according to an embodiment. FIG. 4 shows a DLVR 402 and a die 404, where the DLVR width 406 extends in an x-direction beyond the die width 408. The DLVR 402 may employ a digitally controlled power gate that is modular in the x-direction, which may lead to very long aspect ratios in high current applications. FIG. 4 shows an example of a 50A rated monolithic DLVR 402 positioned below the domain is it intended to supply.

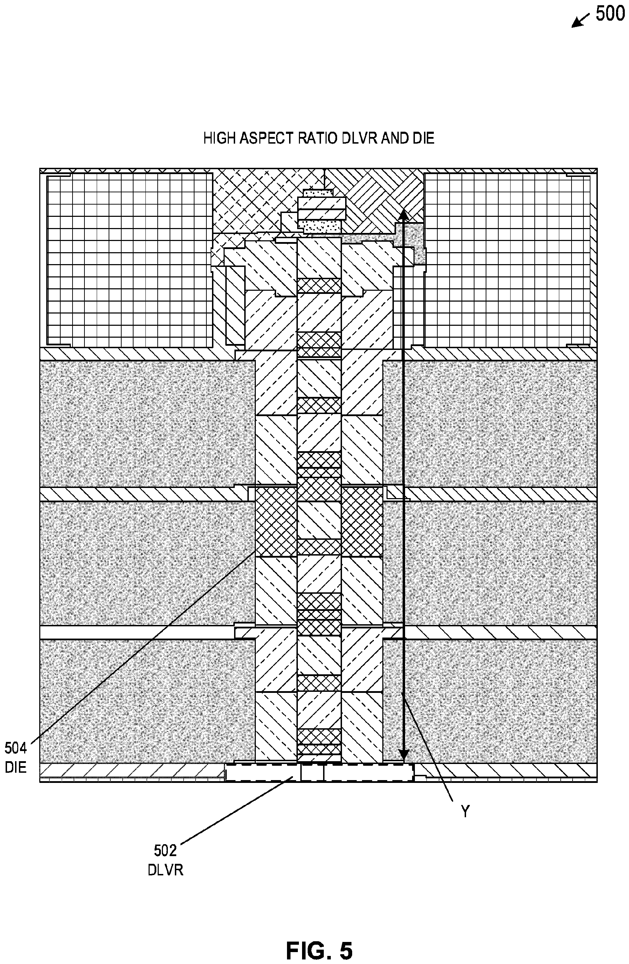

FIG. 5 is a schematic view 500 of a high aspect ratio DLVR and die, according to an embodiment. FIG. 5 shows DLVR 502 and a die 504, such as a monolithic 50A DLVR 502 supplying a very tall power domain (e.g., y > 8 mm) from the bottom. Potential drop (e.g., IR drop) on the power grid from the bottom to the top of the die 504 may be relatively large. Additionally, some power domains are spatially spread out, and there may be a large IR drop on a power grid that spans multiple millimeters. In this example, the IR drop from the bottom to the top of the die 504 will be substantial and may require excess voltage guardband (VGB) to meet minimum voltage (Vmin) requirements at all locations in the domain.

One DLVR ganging solution may include a primary DLVR and one or more secondaries. The primary DLVR may include a voltage sense and active controller, which may forward its PG code to secondary instances. Therm and current sensor rotation may be performed locally at the secondaries and a current monitor (IMON) data may be rolled up from all ganged DLVRs. The ability to distribute voltage regulator power gates may be helpful for power domains that are narrower than the power gate or are very long in one direction. Breaking up a monolithic power gate allows for distribution of smaller segments that are easier to hook up to the power delivery network and may reduce IR drop across large domains. Discussed below is a method of control and communication between a primary controller and secondary power gates in remote locations.

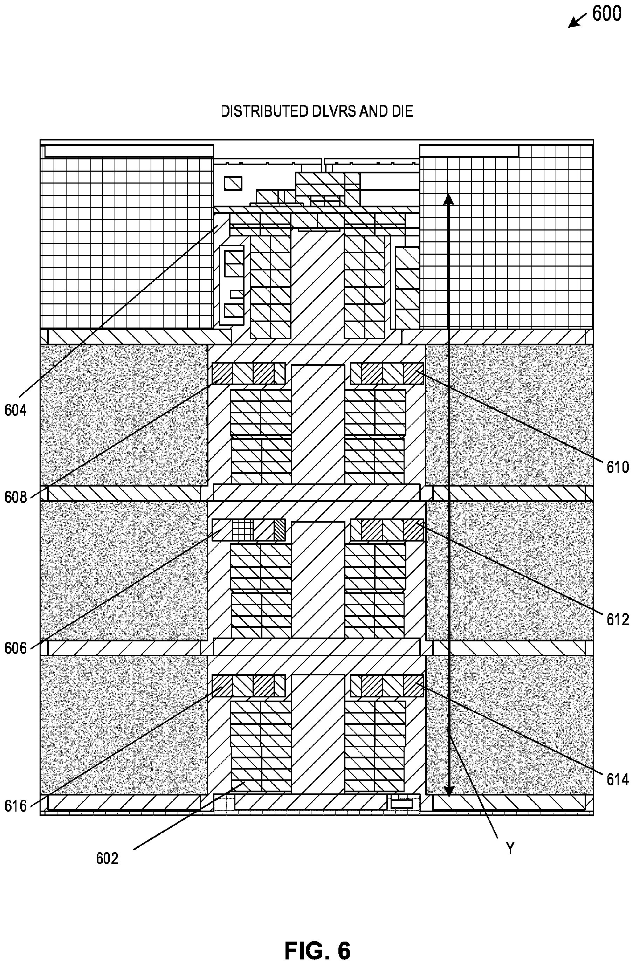

FIG. 6 is a schematic view 600 of distributed DLVRs and a die, according to an embodiment. FIG. 6 shows digital signaling between DLVRs, such as a distributed (e.g., ganged) DLVR composed of a primary 10A DLVR with controller 606 and a handful of secondary 10A DLVRs 608, 610, 612, 614, 616, where current may be distributed evenly and IR drop may be minimized. FIGs. 5 and 6 are discussed together below.

As shown in FIG. 5, a single monolithic DLVR 502 may be instantiated on the lower edge of a large power domain area. There may be a large distance across which the current is distributed by the output power grid, leading to large IR drop and an unnecessarily large guard band voltage (VGB) for the regions near the DLVR. The IR drop problem could be addressed by placing the DLVR in the center of the domain, however there are issues with this approach. One problem is that the DLVR consumes nearly all metal resources within its cell boundary, which makes it difficult to route signal tracks across it, and may effectively divide the output domain into two separate halves that could not communicate with each other. Another problem is the physical size of a monolithic DLVR rated to supply a large domain. As shown in FIG. 5, the 50A rated DLVR is wider than the domain it is supplying. This may cause a non-optimal power delivery scenario in which the power grid must redirect some current laterally back to the area where the load is located, which may increase IR drop along the way.

The ganged DLVR solution shown in FIG. 6 provides improvements over the high aspect ratio DLVR and die shown in FIG. 5. As shown in FIG. 6, a single large DLVR may be separated into smaller ganged blocks. In an example, each DLVR could regulate itself independent of the others, though there may be load current balancing issues potentially leading to bump or metal reliability problems. In another example, a primary DLVR 606 may sense output voltage and broadcast a control signal to all secondary DLVRs (e.g., 608-616) so that they all supply equal currents to the load. In this ganged configuration, the current per branch in each DLVR is locally regulated to a trimmed analog setpoint, effectively turning the individual DLVRs into programmable current sources. A single binary digital code signal may then be broadcast across the domain to enable a defined fraction of the total power gate (e.g., PG code). By broadcasting a single control signal to all power gates rather than allowing them to regulate their local voltages independently, the contention between separate voltage loops is reduced or eliminated. While there is only one main control loop for all the ganged DLVRs, the load current may be regulated in a relatively balanced manner across the span of the output domain. The balancing of current is not achieved by current regulation between the loops, but rather by individual trimmed current feedback loops within each DLVR that maintain a constant current per unit of power gate. Along with branch current regulation, other functions such as binary-to-therm conversion, therm rotation, current sense rotation, and other functions may be performed locally in the secondary DLVRs. This may reduce or minimize the number of signals that are broadcast over the domain, and may keep sensitive internal analog signals from needing any routing outside of the DLVRs.

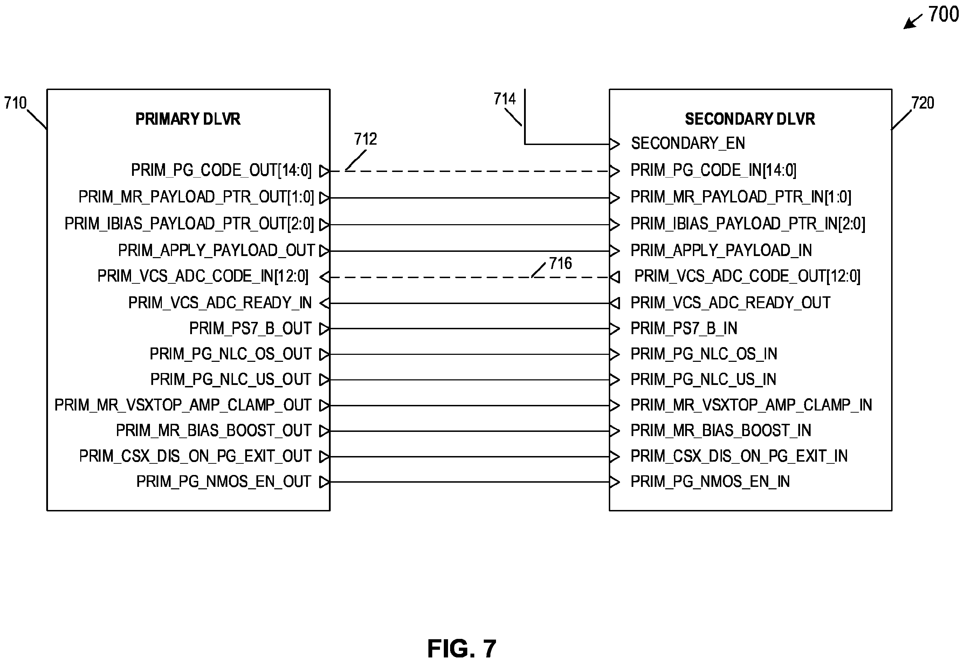

FIG. 7 is a schematic view 700 showing DLVR digital signaling, according to an embodiment. FIG. 7 shows digital signaling between a primary DLVR 710 and a secondary DLVR 720. The DLVR power gate may be controlled with a 15-bit binary code 712 with the 4 most significant binary bits encoded as 15 thermometer bits to drive equally sized therm portions with the power gate. This thermometer encoding may be used to reduced non-monotonicity at large bit transitions (e.g., from 011...111 to 100...000), however such encoding may increase the total number of control signals that must be routed to the power gates from 15 to 26 (e.g., 15bin - 4bin + 15therm = 26).

While routing these extra bits may be relatively trivial within the DLVR IP, the full chip integration level may increase difficulty of acquiring routing resources and ensuring that bits are routed for every DLVR instance according to specifications such as shielding, bundling, and delay. Because of these challenges, it is pragmatic to reduce as much as possible the number of signals going from the primary to the secondaries. To do this, a reduced 15-bit binary PG code may be routed to the secondary DLVRs. The decoding of the 4 most significant bits (MSBs) into thermometer bits may be done locally at each secondary DLVR. In monolithic DLVRs, the power gate therms may be periodically rotated so that the long-term aging effects are evenly distributed over the power gate array. The rotation logic may also be handled locally in the secondary DLVRs to reduce unnecessary full chip routes.

A power state and voltage control finite state machine (FSM) may be present in the primary DLVR. Information may be forwarded from the primary DLVR to all the secondary DLVRs with matched delays, and information may be looped back into the primary DLVR with the same delay, so the settings are applied simultaneously to all DLVRs. This may help to ensure that all DLVRs enter and exit power states and modes synchronously so that there is no transient contention between them. To reduce or minimize the number of signals sent between DLVRs, all settings may be stored locally in each DLVR, and only a 5-bit pointer (e.g., with strobe) may be broadcast to implement various settings.

The full set of signals between primary and secondary DLVRs may be shown in FIG. 7. Most signals may be broadcast from the primary DLVR in parallel to the secondaries. One exception is the current sensor (IMON) signals, which may be sent from the secondaries in a daisy chain configuration back getting summed along the way into the primary where they may be averaged to determine the total domain current rollup. In an example, a secondary enable signal 714 may be hard-tied to indicate that the secondary DLVR 720 is in a secondary role. There may be a total of 42 digital signals routed between the primary DLVR 710 and secondary DLVR 720.

A current sensor and an analog-to-digital controller (ADC) may be used to provide improved current regulation and current sensing. Each of the secondary DLVRs 720 may include a current sensor and an ADC, and may report a digital current value back to the primary DLVR 710, such as through PRIM_VCS_ADC_CODE 716. This current sensing may be used to improve the ability of all power gate transistors in the domain to supply relatively equal amounts of current. Current imbalances may easily occur in the presence of voltage gradients on the input network due to gate-source voltage (VGS) and drain-source voltage (VDS) sensitivity. When current per transistor in a secondary power gate is larger than in the primary, the gain of the overall loop may be higher than expected, which may lead to loop instability. If the transistors in the secondary DLVRs supply less current than the transistors in the primary DLVR, the loop bandwidth may be lower than expected and the ganged power gates may not be able to supply the current required by the load. To reduce or eliminate these situations, ganged control may be used in conjunction with regulators with locally regulated currents. Local current per branch regulation enables constant average current even with voltage gradients on the input power delivery network.

While current regulation may help to keep the current per transistor of each ganged DLVR relatively constant, a dedicated current sensor may be used for accurate current monitoring and fault protection. In the monolithic DLVR, a replica cell may precisely sense gate and junction voltages of the power gate and may provide a proportional amount of current to a central current sensor and an ADC. The digital code from the ADC may represent the current per device, and this code may be multiplied by the PG Code to determine the total current supplied by the DLVR. In a ganged DLVR configuration, each of the DLVRs may include a current sensor and ADC that may report a digital current value per transistor. This code may be sent back to the primary DLVR through a daisy chain signal ADC code 716 as shown in FIG. 7. The primary DLVR may average all the transistor currents reported by the secondaries and may multiply this average with the PG Code to obtain or determine the total current of all the ganged DLVRs.

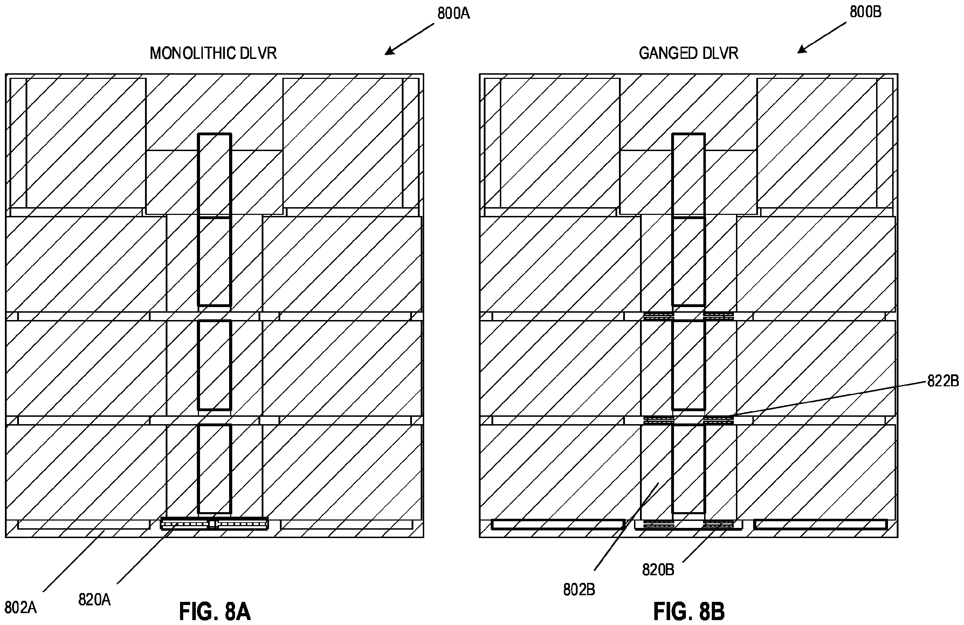

FIGs. 8A-8B are schematic views of DLVR heat maps 800A-800B 800A, according to an embodiment. In particular, FIG. 8A is a schematic view of a monolithic DLVR heat map 800A, and FIG. 8B is a schematic view of a ganged DLVR heat map 800B, where both heat maps 800A and 800B are generated under similar power dissipation conditions. FIGs. 8A and 8B are discussed together below.

In addition to a reduction in IR drop on the power grid, distributed ganged DLVRs may provide a thermal benefit to the power delivery. For example, in a monolithic version of DLVR 802A, power gates 820A are all in close proximity to each other, so any power dissipated as heat in the power gates may be shared with the surrounding power gates. This mutual heating may cause the devices to reach their junction temperature limit much faster.

The ganging feature of the DLVR 802B allows two or more power gates subgroups 820B and 822B to be broken into smaller units that may be separated from each other. The reduction in mutual heating translates directly into increased thermal head room, allowing the ganged DLVRs to dissipate more power per transistor than in the monolithic design. FIG. 8A shows a monolithic DLVR dissipating a lot of power and heating up in the concentrated region of power gates 820A, while FIG. 8B shows the same power dissipated in two or more power gates subgroups 820B and 822B. Because the ganged DLVRs are spread apart there is less mutual heating, so their junctions remain at a lower temperature than in the monolithic DLVR.

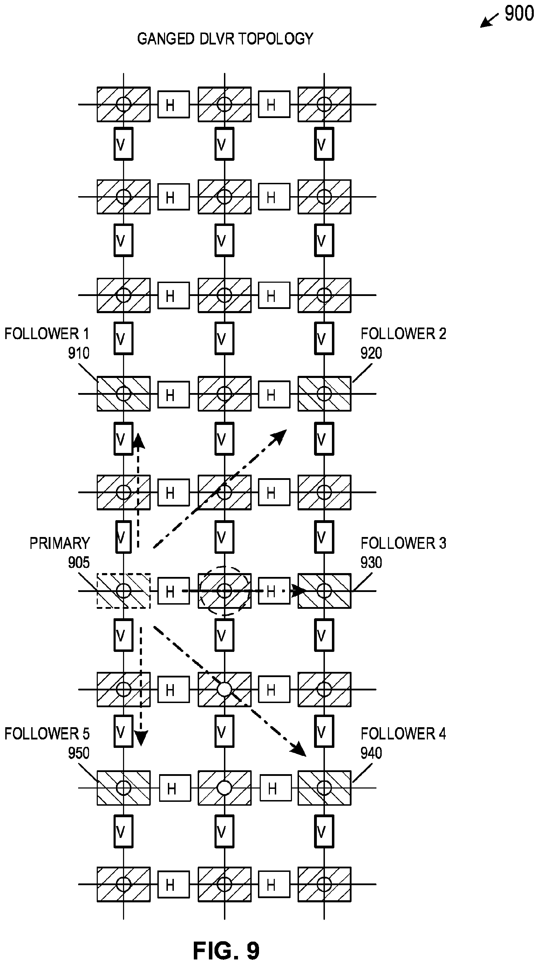

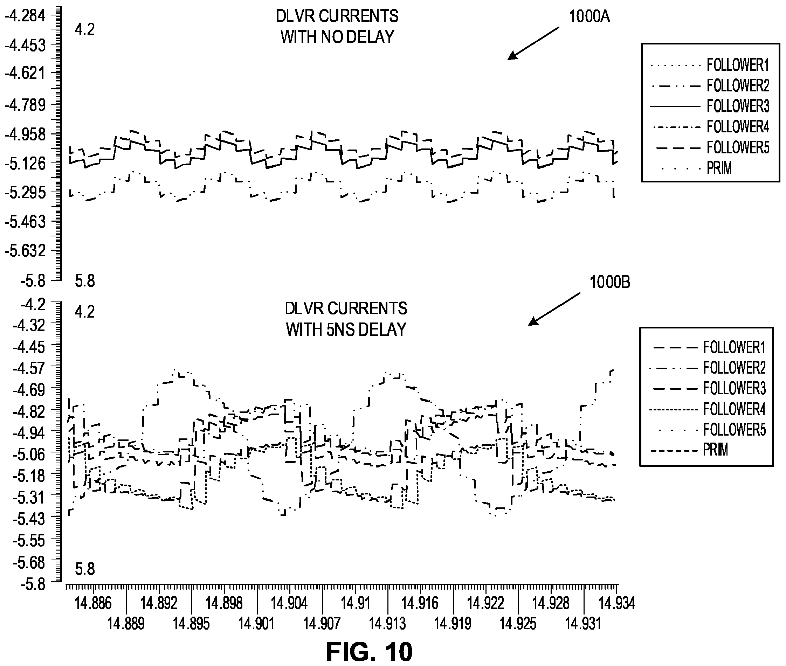

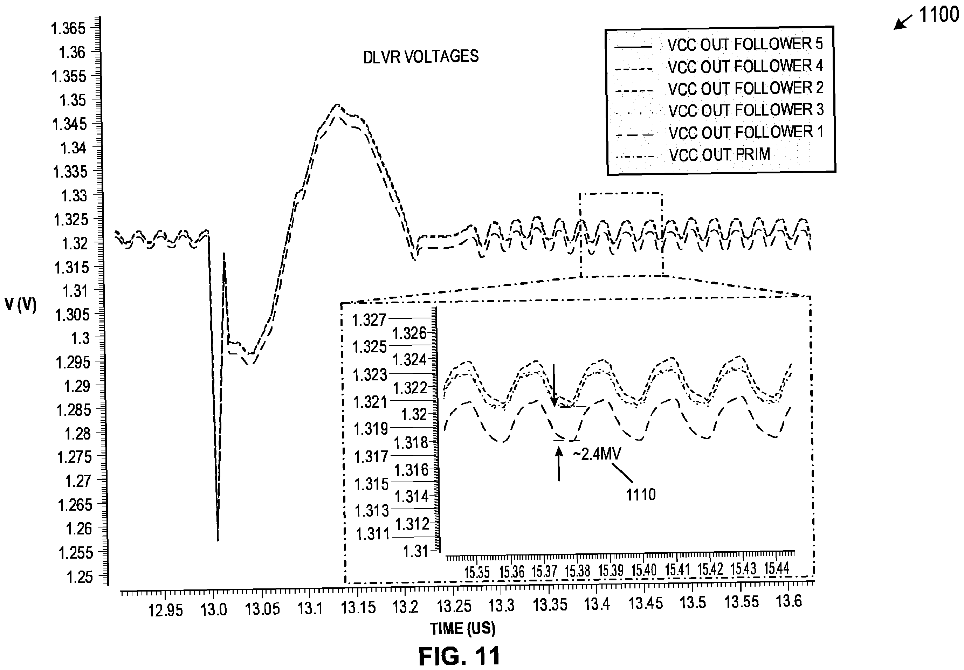

FIG. 9 is a schematic view of a simulated ganged DLVR topology 900, according to an embodiment. The ganged DLVR topology may include a primary DLVR 905 and five secondary DLVRs 910-950. The ganged DLVR topology 900 may be used to compare simulated DLVR currents with and without PG code delay, such as the simulated output DLVR currents shown in FIG. 10 and the simulated output DLVR voltages shown in FIG. 11.

As described above, there are several advantages of ganging several small regulators, such as reduced power grid voltage gradients and easier integration of large power gates. However, the distributed nature of the ganged DLVRs may increase delay in the linear control loop, and the delay may contribute to loss of phase margin in high bandwidth control loops. For example, a loop with a 50MHz unity gain bandwidth and 1ns delay in its control path may exhibit 18° less phase margin than the same loop with no delay. While the delay of the PG code from primary to secondary DLVRs should be minimized to maintain loop bandwidth as high as possible, the controller difference equation coefficients may be used to compensate for any increased delay and avoid pushing the bandwidth higher than stability limits allow. Routing delays may be significant, but these routing delays are offset by the additional available area for output capacitance within domains that would require ganged regulators. By using a large capacitance to reduce the high frequency impedance, the regulator control loop bandwidth may be relaxed accordingly without a first-order effect on peak impedance.

FIG. 10 is a graph of simulated output DLVR currents 1000, according to an embodiment. The simulated output DLVR currents 1000 shown in FIG. 10 correspond to the primary DLVR 905 and five secondary DLVRs 910-950 shown in FIG. 9. A top plot 1000A shows well balanced currents when there is no delay between the primary DLVR and secondary DLVRs. A bottom plot 100B shows a situation when there is a 5ns delay between the primary DLVR and secondary DLVRs. As can be seen in delay plot 100B, one effect of the delay is larger current swings as the primary DLVR attempts to negate the over-currents and under-currents of the secondary DLVRs.

FIG. 11 is a graph of simulated output DLVR voltages 1100, according to an embodiment. The simulated output DLVR voltages 1100 shown in FIG. 11 correspond to the primary DLVR 905 and five secondary DLVR 910-950 shown in FIG. 9. If delay between DLVRs is considered when tuning the frequency response of the voltage loop controller, a unity gain bandwidth may be targeted, and a stable recipe may be found. In an example, the evenly distributed load capacitance is approximately 2.5uF and the evenly distributed load current step is a ramp from 8.5A to 30.3A in 3.35ns. The 2.4mV voltage difference 1110 between the outputs of the primary DLVR and both secondary DLVR 1 and secondary DLVR 2 are due to the excess load drawn from the large area above the DLVRs. Even compared to the 2.4mV voltage difference 1110, the voltage drop at these locations would be much higher for a single monolithic DLVR with sense point located at the bottom of the power domain.

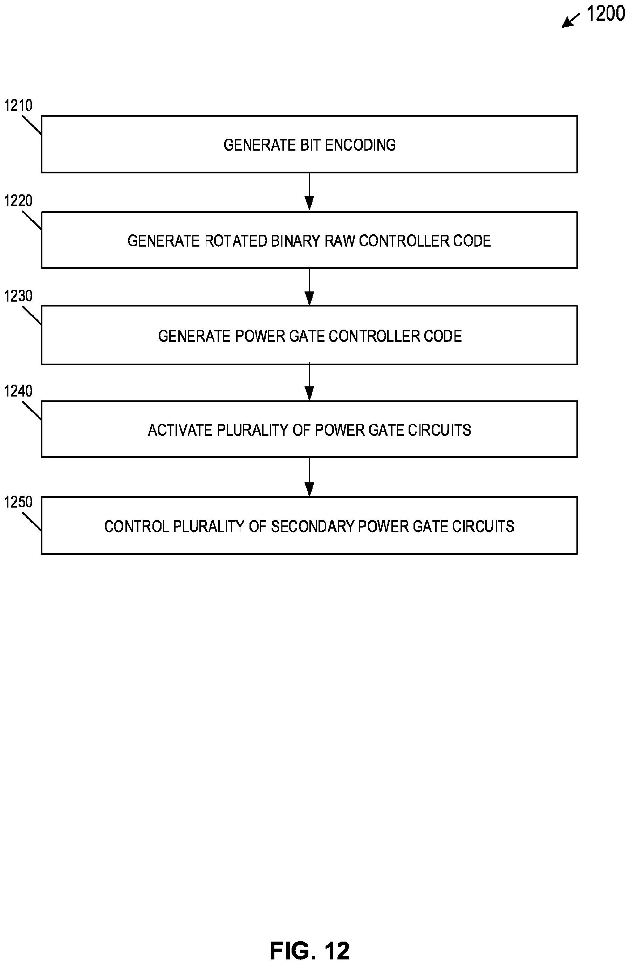

FIG. 12 is a flowchart illustrating a method 1200, according to an embodiment. Method 1200 includes generating 1210 a bit encoding at a power code generation circuit based on a received power request, generating 1220 a rotated binary raw controller code at a deterministic code rotation circuit based on the bit encoding and based on a previous binary controller code, generating 1230 a power gate controller code at a controller based on the rotated binary raw controller code, and activating 1240 a plurality of power gate circuits within a digital power gate regulator based on the power gate controller code. Method 1200 may further include controlling 1250 a plurality of secondary power gate circuits based on the power gate controller code and a secondary power gate delay.

In an example, the previous binary controller code may identify a first subset of the plurality of power gate circuits. The rotated binary raw controller code may identify a second subset of the plurality of power gate circuits different from the first subset of the plurality of power gate circuits. The bit encoding may include a plurality of binary weighted bits corresponding to a plurality of binary weighted power gate units and a plurality of equally weighted bits corresponding to a first subset of equally weighted thermometer power gate units. The rotated binary raw controller code may identify a plurality of rotated equally weighted bits corresponding to a second subset of equally weighted thermometer power gate units.

The first subset of equally weighted thermometer power gate units may include a first initial thermometer-encoded power gate unit. Similarly, the second subset of equally weighted thermometer power gate units may include a second initial thermometer-encoded power gate unit, where the second initial thermometer-encoded power gate unit is different from the first initial thermometer-encoded power gate unit. The second initial thermometer-encoded power gate unit may be adjacent to the first initial thermometer-encoded power gate unit to provide a sequential power gate unit cycle. The second initial thermometer-encoded power gate unit may be separated by a rotation distance from the first initial thermometer-encoded power gate unit to provide a distributed power gate unit cycle.

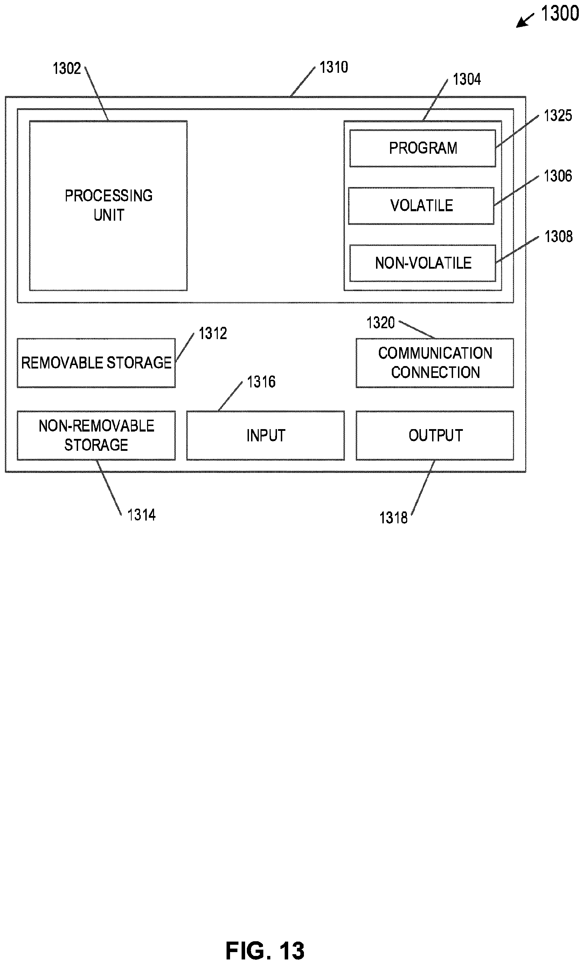

FIG. 13 is a block diagram of a computing device 1300, according to an embodiment. The performance of one or more components within computing device 1300 may be improved by including one or more of the circuits or circuitry methods described herein. Computing device 1300 may include a digital power gate regulator including a plurality of power gate circuits, a power code generation circuit to generate a bit encoding based on a received power request, a deterministic code rotation circuit to generate a rotated binary raw controller code based on the bit encoding and based on a previous binary controller code, and a controller to generate a power gate controller code based on the rotated binary raw controller code.

In one embodiment, multiple such computer systems are used in a distributed network to implement multiple components in a transaction-based environment. An object-oriented, service-oriented, or other architecture may be used to implement such functions and communicate between the multiple systems and components. In some embodiments, the computing device of FIG. 13 is an example of a client device that may invoke methods described herein over a network. In other embodiments, the computing device is an example of a computing device that may be included in or connected to a motion interactive video projection system, as described elsewhere herein. In some embodiments, the computing device of FIG. 13 is an example of one or more of the personal computer, smartphone, tablet, or various servers.

One example computing device in the form of a computer 1310, may include a processing unit 1302, memory 1304, removable storage 1312, and non-removable storage 1314. Although the example computing device is illustrated and described as computer 1310, the computing device may be in different forms in different embodiments. For example, the computing device may instead be a smartphone, a tablet, or other computing device including the same or similar elements as illustrated and described regarding FIG. 13. Further, although the various data storage elements are illustrated as part of the computer 1310, the storage may include cloud-based storage accessible via a network, such as the Internet.

Returning to the computer 1310, memory 1304 may include volatile memory 1306 and non-volatile memory 1308. Computer 1310 may include or have access to a computing environment that includes a variety of computer-readable media, such as volatile memory 1306 and non-volatile memory 1308, removable storage 1312 and non-removable storage 1314. Computer storage includes random access memory (RAM), read only memory (ROM), erasable programmable read-only memory (EPROM) & electrically erasable programmable read-only memory (EEPROM), flash memory or other memory technologies, compact disc read-only memory (CD ROM), Digital Versatile Disks (DVD) or other optical disk storage, magnetic cassettes, magnetic tape, magnetic disk storage or other magnetic storage devices, or any other medium capable of storing computer-readable instructions. Computer 1310 may include or have access to a computing environment that includes input 1316, output 1318, and a communication connection 1320. The input 1316 may include one or more of a touchscreen, touchpad, mouse, keyboard, camera, and other input devices. The input 1316 may include a navigation sensor input, such as a GNSS receiver, a SOP receiver, an inertial sensor (e.g., accelerometers, gyroscopes), a local ranging sensor (e.g., LIDAR), an optical sensor (e.g., cameras), or other sensors. The computer may operate in a networked environment using a communication connection 1320 to connect to one or more remote computers, such as database servers, web servers, and other computing devices. An example remote computer may include a personal computer (PC), server, router, network PC, a peer device or other common network node, or the like. The communication connection 1320 may be a network interface device such as one or both of an Ethernet card and a wireless card or circuit that may be connected to a network. The network may include one or more of a Local Area Network (LAN), a Wide Area Network (WAN), the Internet, and other networks.

Computer-readable instructions stored on a computer-readable medium are executable by the processing unit 1302 of the computer 1310. A hard drive (magnetic disk or solid state), CD-ROM, and RAM are some examples of articles including a non-transitory computer-readable medium. For example, various computer programs 1325 or apps, such as one or more applications and modules implementing one or more of the methods illustrated and described herein or an app or application that executes on a mobile device or is accessible via a web browser, may be stored on a non-transitory computer-readable medium.

The apparatuses and methods described above may include or be included in high-speed computers, communication and signal processing circuitry, single-processor module or multiprocessor modules, single embedded processors or multiple embedded processors, multi-core processors, message information switches, and application-specific modules including multilayer or multi-chip modules. Such apparatuses may further be included as sub-components within a variety of other apparatuses (e.g., electronic systems), such as televisions, cellular telephones, personal computers (e.g., laptop computers, desktop computers, handheld computers, etc.), tablets (e.g., tablet computers), workstations, radios, video players, audio players (e.g., MP3 (Motion Picture Experts Group, Audio Layer 3) players), vehicles, medical devices (e.g., heart monitors, blood pressure monitors, etc.), set top boxes, and others.

In the detailed description and the claims, the term "on" used with respect to two or more elements (e.g., materials), one "on" the other, means at least some contact between the elements (e.g., between the materials). The term "over" means the elements (e.g., materials) are in close proximity, but possibly with one or more additional intervening elements (e.g., materials) such that contact is possible but not required. Neither "on" nor "over" implies any directionality as used herein unless stated as such.

In the detailed description and the claims, a list of items joined by the term "at least one of' may mean any combination of the listed items. For example, if items A and B are listed, then the phrase "at least one of A and B" means A only; B only; or A and B. In another example, if items A, B, and C are listed, then the phrase "at least one of A, B and C" means A only; B only; C only; A and B (excluding C); A and C (excluding B); B and C (excluding A); or all of A, B, and C. Item A may include a single element or multiple elements. Item B may include a single element or multiple elements. Item C may include a single element or multiple elements.

In the detailed description and the claims, a list of items joined by the term "one of' may mean only one of the list items. For example, if items A and B are listed, then the phrase "one of A and B" means A only (excluding B), or B only (excluding A). In another example, if items A, B, and C are listed, then the phrase "one of A, B and C" means A only; B only; or C only. Item A may include a single element or multiple elements. Item B may include a single element or multiple elements. Item C may include a single element or multiple elements.

Example 1 is a digital voltage regulation apparatus comprising: a digital power gate regulator including a plurality of power gate circuits; a power code generation circuit to generate a bit encoding based on a received power request; a deterministic code rotation circuit to generate a rotated binary raw controller code based on the bit encoding and based on a previous binary controller code; and a controller to generate a power gate controller code based on the rotated binary raw controller code.

In Example 2, the subject matter of Example 1 includes, wherein: the previous binary controller code identifies a first subset of the plurality of power gate circuits; and the rotated binary raw controller code identifies a second subset of the plurality of power gate circuits different from the first subset of the plurality of power gate circuits.

In Example 3, the subject matter of Examples 1-2 includes, wherein the bit encoding includes: a plurality of binary weighted bits corresponding to a plurality of binary weighted power gate units; and a plurality of equally weighted bits corresponding to a first subset of equally weighted thermometer power gate units.

In Example 4, the subject matter of Example 3 includes, wherein the rotated binary raw controller code identifies a plurality of rotated equally weighted bits corresponding to a second subset of equally weighted thermometer power gate units.

In Example 5, the subject matter of Example 4 includes, wherein: the first subset of equally weighted thermometer power gate units includes a first initial thermometer-encoded power gate unit; the second subset of equally weighted thermometer power gate units includes a second initial thermometer-encoded power gate unit; and the second initial thermometer-encoded power gate unit is different from the first initial thermometer-encoded power gate unit.

In Example 6, the subject matter of Example 5 includes, wherein the second initial thermometer-encoded power gate unit is adjacent to the first initial thermometer-encoded power gate unit to provide a sequential power gate unit cycle.

In Example 7, the subject matter of Examples 5-6 includes, wherein the second initial thermometer-encoded power gate unit is separated by a rotation distance from the first initial thermometer-encoded power gate unit to provide a distributed power gate unit cycle.

In Example 8, the subject matter of Examples 1-7 includes, a secondary power gate regulator including a plurality of secondary power gate circuits.

In Example 9, the subject matter of Example 8 includes, wherein the primary power gate regulator controls the plurality of secondary power gate circuits based on the power gate controller code and a secondary power gate delay.

Example 10 is a digital voltage regulation method comprising: generating a bit encoding at a power code generation circuit based on a received power request; generating a rotated binary raw controller code at a deterministic code rotation circuit based on the bit encoding and based on a previous binary controller code; generating a power gate controller code at a controller based on the rotated binary raw controller code; and activating a plurality of power gate circuits within a digital power gate regulator based on the power gate controller code.

In Example 11, the subject matter of Example 10 includes, wherein: the previous binary controller code identifies a first subset of the plurality of power gate circuits; and the rotated binary raw controller code identifies a second subset of the plurality of power gate circuits different from the first subset of the plurality of power gate circuits.

In Example 12, the subject matter of Examples 10-11 includes, wherein the bit encoding includes: a plurality of binary weighted bits corresponding to a plurality of binary weighted power gate units; and a plurality of equally weighted bits corresponding to a first subset of equally weighted thermometer power gate units.

In Example 13, the subject matter of Example 12 includes, wherein the rotated binary raw controller code identifies a plurality of rotated equally weighted bits corresponding to a second subset of equally weighted thermometer power gate units.

In Example 14, the subject matter of Example 13 includes, wherein: the first subset of equally weighted thermometer power gate units includes a first initial thermometer-encoded power gate unit; the second subset of equally weighted thermometer power gate units includes a second initial thermometer-encoded power gate unit; and the second initial thermometer-encoded power gate unit is different from the first initial thermometer-encoded power gate unit.

In Example 15, the subject matter of Example 14 includes, wherein the second initial thermometer-encoded power gate unit is adjacent to the first initial thermometer-encoded power gate unit to provide a sequential power gate unit cycle.

In Example 16, the subject matter of Examples 14-15 includes, wherein the second initial thermometer-encoded power gate unit is separated by a rotation distance from the first initial thermometer-encoded power gate unit to provide a distributed power gate unit cycle.

In Example 17, the subject matter of Examples 10-16 includes, controlling a plurality of secondary power gate circuits based on the power gate controller code and a secondary power gate delay.

Example 18 is at least one non-transitory machine-readable storage medium, comprising a plurality of instructions that, responsive to being executed with processor circuitry of a computer-controlled device, cause the processing circuitry to: generate a bit encoding at a power code generation circuit based on a received power request; generate a rotated binary raw controller code at a deterministic code rotation circuit based on the bit encoding and based on a previous binary controller code; generate a power gate controller code at a controller based on the rotated binary raw controller code; and activate a plurality of power gate circuits within a digital power gate regulator based on the power gate controller code.

In Example 19, the subject matter of Example 18 includes, wherein: the previous binary controller code identifies a first subset of the plurality of power gate circuits; and the rotated binary raw controller code identifies a second subset of the plurality of power gate circuits different from the first subset of the plurality of power gate circuits.

In Example 20, the subject matter of Examples 18-19 includes, wherein the bit encoding includes: a plurality of binary weighted bits corresponding to a plurality of binary weighted power gate units; and a plurality of equally weighted bits corresponding to a first subset of equally weighted thermometer power gate units.

In Example 21, the subject matter of Example 20 includes, wherein the rotated binary raw controller code identifies a plurality of rotated equally weighted bits corresponding to a second subset of equally weighted thermometer power gate units.

In Example 22, the subject matter of Example 21 includes, wherein: the first subset of equally weighted thermometer power gate units includes a first initial thermometer-encoded power gate unit; the second subset of equally weighted thermometer power gate units includes a second initial thermometer-encoded power gate unit; and the second initial thermometer-encoded power gate unit is different from the first initial thermometer-encoded power gate unit.

In Example 23, the subject matter of Example 22 includes, wherein the second initial thermometer-encoded power gate unit is adjacent to the first initial thermometer-encoded power gate unit to provide a sequential power gate unit cycle.

In Example 24, the subject matter of Examples 22-23 includes, wherein the second initial thermometer-encoded power gate unit is separated by a rotation distance from the first initial thermometer-encoded power gate unit to provide a distributed power gate unit cycle.

In Example 25, the subject matter of Examples 18-24 includes, the instructions further causing the processing circuitry to control a plurality of secondary power gate circuits based on the power gate controller code and a secondary power gate delay.

Example 26 is a digital voltage regulation apparatus, the apparatus comprising: means for generating a bit encoding at a power code generation circuit based on a received power request; means for generating a rotated binary raw controller code at a deterministic code rotation circuit based on the bit encoding and based on a previous binary controller code; means for generating a power gate controller code at a controller based on the rotated binary raw controller code; and means for activating a plurality of power gate circuits within a digital power gate regulator based on the power gate controller code.

In Example 27, the subject matter of Example 26 includes, wherein: the previous binary controller code identifies a first subset of the plurality of power gate circuits; and the rotated binary raw controller code identifies a second subset of the plurality of power gate circuits different from the first subset of the plurality of power gate circuits.

In Example 28, the subject matter of Examples 26-27 includes, wherein the bit encoding includes: a plurality of binary weighted bits corresponding to a plurality of binary weighted power gate units; and a plurality of equally weighted bits corresponding to a first subset of equally weighted thermometer power gate units.

In Example 29, the subject matter of Example 28 includes, wherein the rotated binary raw controller code identifies a plurality of rotated equally weighted bits corresponding to a second subset of equally weighted thermometer power gate units.

In Example 30, the subject matter of Example 29 includes, wherein: the first subset of equally weighted thermometer power gate units includes a first initial thermometer-encoded power gate unit; the second subset of equally weighted thermometer power gate units includes a second initial thermometer-encoded power gate unit; and the second initial thermometer-encoded power gate unit is different from the first initial thermometer-encoded power gate unit.

In Example 31, the subject matter of Example 30 includes, wherein the second initial thermometer-encoded power gate unit is adjacent to the first initial thermometer-encoded power gate unit to provide a sequential power gate unit cycle.

In Example 32, the subject matter of Examples 30-31 includes, wherein the second initial thermometer-encoded power gate unit is separated by a rotation distance from the first initial thermometer-encoded power gate unit to provide a distributed power gate unit cycle.

In Example 33, the subject matter of Examples 26-32 includes, means for controlling a plurality of secondary power gate circuits based on the power gate controller code and a secondary power gate delay.

Example 34 is a digital voltage regulation apparatus comprising: a digital power gate regulator coupled to a plurality of power gate circuits; a power code generation circuit coupled to the digital power gate regulator; a deterministic code rotation circuit coupled to the power code generation circuit; and a controller circuit coupled to the deterministic code rotation circuit and the digital power gate regulator.

In Example 35, the subject matter of Example 34 includes, wherein the plurality of power gate circuits includes: a plurality of binary weighted power gate units coupled to the digital power gate regulator; a first subset of equally weighted thermometer power gate units coupled to the digital power gate regulator; and a second subset of equally weighted thermometer power gate units coupled to the digital power gate regulator.

In Example 36, the subject matter of Example 35 includes, wherein the plurality of power gate circuits further includes a second subset of equally weighted thermometer power gate units.

In Example 37, the subject matter of Examples 34-36 includes, a secondary power gate regulator coupled to the digital power gate regulator, the secondary power gate regulator including a plurality of secondary power gate circuits.

Example 38 is at least one machine-readable medium including instructions that, when executed by processing circuitry, cause the processing circuitry to perform operations to implement of any of Examples 1-37.

Example 39 is an apparatus comprising means to implement of any of Examples 1-37.

Example 40 is a system to implement of any of Examples 1-37.

Example 41 is a method to implement of any of Examples 1-37.

The subject matter of any Examples above may be combined in any combination.

The above description and the drawings illustrate some embodiments of the inventive subject matter to enable those skilled in the art to practice the embodiments of the inventive subject matter. Other embodiments may incorporate structural, logical, electrical, process, and other changes. Examples merely typify possible variations. Portions and features of some embodiments may be included in, or substituted for, those of others. Many other embodiments will be apparent to those of skill in the art upon reading and understanding the above description.

The Abstract is provided to comply with 37 C.F.R. Section 1.72(b) requiring an abstract that will allow the reader to ascertain the nature and gist of the technical disclosure. It is submitted with the understanding that it will not be used to limit or interpret the scope or meaning of the claims. The following claims are hereby incorporated into the detailed description, with each claim standing on its own as a separate embodiment.

## Claims

1. A digital voltage regulation apparatus comprising:
a digital power gate regulator including a plurality of power gate circuits;
a power code generation circuit to generate a bit encoding based on a received power request;
a deterministic code rotation circuit to generate a rotated binary raw controller code based on the bit encoding and based on a previous binary controller code; and
a controller to generate a power gate controller code based on the rotated binary raw controller code.

2. The digital voltage regulation apparatus of claim 1, wherein:
the previous binary controller code identifies a first subset of the plurality of power gate circuits; and
the rotated binary raw controller code identifies a second subset of the plurality of power gate circuits different from the first subset of the plurality of power gate circuits.

3. The digital voltage regulation apparatus of any of claims 1-2, wherein the bit encoding includes:
a plurality of binary weighted bits corresponding to a plurality of binary weighted power gate units; and
a plurality of equally weighted bits corresponding to a first subset of equally weighted thermometer power gate units.

4. The digital voltage regulation apparatus of claim 3, wherein the rotated binary raw controller code identifies a plurality of rotated equally weighted bits corresponding to a second subset of equally weighted thermometer power gate units.

5. The digital voltage regulation apparatus of claim 4, wherein:
the first subset of equally weighted thermometer power gate units includes a first initial thermometer-encoded power gate unit;
the second subset of equally weighted thermometer power gate units includes a second initial thermometer-encoded power gate unit; and
the second initial thermometer-encoded power gate unit is different from the first initial thermometer-encoded power gate unit.

6. The digital voltage regulation apparatus of claim 5, wherein the second initial thermometer-encoded power gate unit is adjacent to the first initial thermometer-encoded power gate unit to provide a sequential power gate unit cycle.

7. The digital voltage regulation apparatus of any of claims 5-6, wherein the second initial thermometer-encoded power gate unit is separated by a rotation distance from the first initial thermometer-encoded power gate unit to provide a distributed power gate unit cycle.

8. A digital voltage regulation method comprising:
generating a bit encoding at a power code generation circuit based on a received power request;
generating a rotated binary raw controller code at a deterministic code rotation circuit based on the bit encoding and based on a previous binary controller code;
generating a power gate controller code at a controller based on the rotated binary raw controller code; and
activating a plurality of power gate circuits within a digital power gate regulator based on the power gate controller code.

9. The digital voltage regulation method of claim 8, wherein:
the previous binary controller code identifies a first subset of the plurality of power gate circuits; and
the rotated binary raw controller code identifies a second subset of the plurality of power gate circuits different from the first subset of the plurality of power gate circuits.

10. The digital voltage regulation method of any of claims 8-9, wherein the bit encoding includes:
a plurality of binary weighted bits corresponding to a plurality of binary weighted power gate units; and
a plurality of equally weighted bits corresponding to a first subset of equally weighted thermometer power gate units.

11. The digital voltage regulation method of claim 10, wherein the rotated binary raw controller code identifies a plurality of rotated equally weighted bits corresponding to a second subset of equally weighted thermometer power gate units.

12. The digital voltage regulation method of claim 11, wherein:
the first subset of equally weighted thermometer power gate units includes a first initial thermometer-encoded power gate unit;
the second subset of equally weighted thermometer power gate units includes a second initial thermometer-encoded power gate unit; and
the second initial thermometer-encoded power gate unit is different from the first initial thermometer-encoded power gate unit.

13. The digital voltage regulation method of claim 12, wherein the second initial thermometer-encoded power gate unit is adjacent to the first initial thermometer-encoded power gate unit to provide a sequential power gate unit cycle.

14. Machine-readable storage including machine-readable instructions, when executed by a computer, cause the computer to implement a method as claimed in any of claims 8-13.

15. A computer program comprising instructions which, when the program is executed by a computer, cause the computer to carry out the method as claimed in any of claims 8-13.
